# FASCICULE DE BREVET EUROPEEN

(11) **EP 4 032 131 B1**
(45) Date de publication et mention de la délivrance du brevet: **26.07.2023**
(21) Numéro de dépôt: 20801335.9
(22) Date de dépôt: 14.10.2020
(51) Int. Cl.: H01L 31/048, H01L 31/049

(54) **MODULE PHOTOVOLTAÏQUE COMPORTANT UN ÉLÉMENT DE LIAISON CONDUCTEUR ÉLECTRIQUEMENT**
FOTOVOLTAIKMODUL MIT EINEM ELEKTRISCH LEITENDEN VERBINDUNGSELEMENT
PHOTOVOLTAIC MODULE COMPRISING AN ELECTRICALLY CONDUCTIVE CONNECTION ELEMENT

(30) Priorité: 24.10.2019 FR 1911899
(43) Date de publication de la demande: 27.07.2022
(73) Titulaire: Commissariat à l'Energie Atomique et aux Energies Alternatives, 75015 Paris (FR)
(72) Inventeur: GAUME, Julien, 38054 GRENOBLE CEDEX 09 (FR); GUERIN, Thomas, 38054 GRENOBLE Cedex 09 (FR)
(74) Mandataire: Brevalex
(86) Numéro de dépôt international: PCT/FR2020/051810
(87) Numéro de publication internationale: WO 2021/079043

(56) Documents cités:
- US-A- 4 433 201
- US-A- 5 919 316
- US-A1- 2003 034 062
- US-B1- 6 320 114

## Description

### DOMAINE TECHNIQUE

La présente invention se rapporte au domaine des modules photovoltaïques, qui comportent un ensemble de cellules photovoltaïques reliées entre elles électriquement, et préférentiellement des cellules photovoltaïques dites « cristallines », c'est-à-dire qui sont à base de silicium monocristallin ou multicristallin.

L'invention se rapporte à tous les types de modules photovoltaïques, et notamment ceux avec une face avant en matériau plastique et utilisés dans des applications en mouvement où ils subissent le frottement de l'air. Plus spécifiquement, l'invention peut concerner le domaine des modules photovoltaïques dépourvus de verre, qualifiés d'« ultra-légers », à savoir avec une masse surfacique inférieure à 1 kg/m², flexibles et de faible épaisseur, à savoir avec une épaisseur inférieure à 2 mm.

L'invention peut être mise en oeuvre pour de nombreuses applications, et tout particulièrement pour des dispositifs en mouvement dans l'air tels que des véhicules terrestres ou aériens, par exemple des voitures, bus, avions, drones, ballons dirigeables, satellites, entre autres.

L'invention propose ainsi un module photovoltaïque comportant un élément de liaison conducteur électriquement, relié à la face arrière du module, pour permettre l'évacuation de charges électrostatiques accumulées au niveau de la face avant du module.

### ÉTAT DE LA TECHNIQUE ANTÉRIEURE

Un module photovoltaïque est un assemblage de cellules photovoltaïques disposées côte à côte entre une première couche transparente formant une face avant du module photovoltaïque et une seconde couche formant une face arrière du module photovoltaïque.

La première couche formant la face avant du module photovoltaïque est avantageusement transparente pour permettre aux cellules photovoltaïques de recevoir un flux lumineux. Pour un module ultra-léger sans verre, elle peut comporter des feuilles de polymères comme le polyfluorure de vinylidène (PVDF), l'éthylène tétrafluoroéthylène (ETFE), l'éthylène chlorotrifluoroéthylène (ECTFE), l'éthylène propylène fluoré (FEP), le polyméthacrylate de méthyle (PMMA), le polycarbonate (PC), entre autres, ou bien encore des matériaux composites de type préimprégnés (ou « prepreg » en anglais) avec des renforts de type verre polymère synthétique, par exemple des aramides.

La deuxième couche formant la face arrière du module photovoltaïque peut quant à elle être réalisée à base de film polymère ou de matériaux composites de type préimprégnés, à base de renforts de type verre ou autre.

Les cellules photovoltaïques peuvent être reliées électriquement entre elles (interconnectées) par des éléments de contact électrique avant et arrière, appelés conducteurs de liaison, et formés par exemple par des bandes (ou rubans) ou fils de cuivre étamé.

Par ailleurs, les cellules photovoltaïques, situées entre les première et deuxième couches formant respectivement les faces avant et arrière du module photovoltaïque, peuvent être encapsulées. L'encapsulant peut être réalisé à partir d'au moins un matériau polymère choisi parmi : les copolymères d'acides, les ionomères, le poly(éthylène-acétate de vinyle) (EVA), les acétals de vinyle , tels que les polyvinylbutyrals (PVB), les polyuréthanes, les chlorures de polyvinyle, les polyéthylènes, tels que les polyéthylènes linéaires basse densité, les polyoléfines élastomères de copolymères, les copolymères d'a-oléfines et des α-, β- esters d'acide carboxylique à éthylénique, tels que les copolymères éthylène-acrylate de méthyle et les copolymères éthylène-acrylate de butyle, les élastomères de silicone et/ou les résines époxy, entre autres.

Ces différentes couches sont mises en oeuvre par un procédé de lamination à chaud, à environ 150°C, sous vide pour l'obtention du module photovoltaïque.

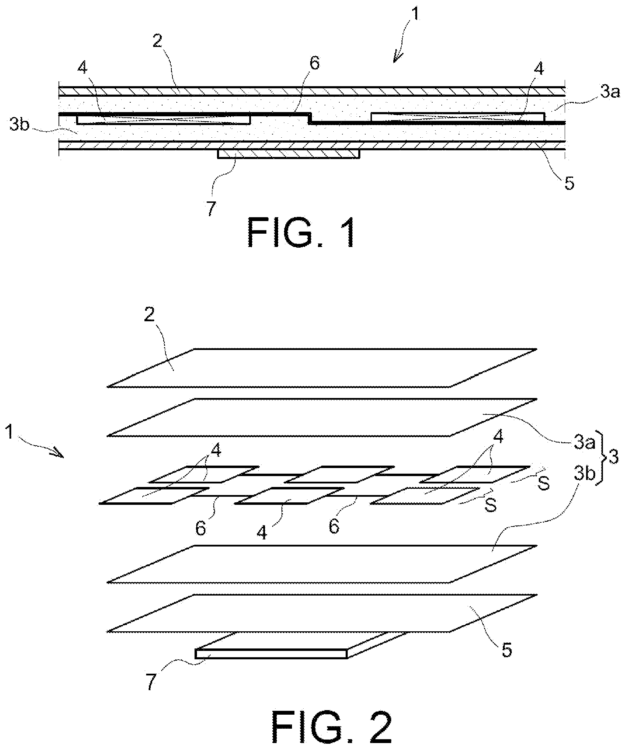

On a ainsi représenté partiellement et schématiquement, respectivement en coupe sur la figure 1 et en vue éclatée sur la figure 2, un exemple classique de module photovoltaïque 1 comportant des cellules photovoltaïques 4 cristallines.

Comme décrit précédemment, le module photovoltaïque 1 comporte une face avant 2 et une face arrière 5. Entre la face avant 2 et la face arrière 5 du module photovoltaïque 1 se situent les cellules photovoltaïques 4, reliées électriquement entre elles par des conducteurs de liaison 6 et immergées entre une couche avant 3a et une couche arrière 3b de matériau d'encapsulation formant toutes les deux un ensemble encapsulant 3.

Ainsi, un module photovoltaïque comprend une multitude de cellules photovoltaïques identiques connectées en série et/ou en parallèle afin de fournir en sortie la tension et/ou le courant requis pour alimenter des dispositifs électriques. Le format de module le plus courant emploie 60 cellules carrées, ou « pseudo-carrées », d'environ 156 mm de côté, réparties en six chaînes ou séries S, comme visible sur la figure 2, appelées encore « strings » selon la dénomination anglaise, de dix cellules interconnectées en série. Les six chaînes de cellules photovoltaïques sont également interconnectées en série.

Les porteurs de charge photogénérés, qui contribuent au courant électrique de la cellule photovoltaïque, sont collectés grâce à un réseau d'électrodes déposé sur la face avant de la cellule. Ces électrodes, appelées également doigts de collecte, sont étroites, typiquement de dimension inférieure à 100 µm. Elles sont généralement formées par sérigraphie d'une pâte contenant de l'argent. La face arrière de la cellule est soit recouverte d'un autre réseau d'électrodes (cas des cellules bifaciales), soit d'une couche métallique pleine, par exemple en aluminium (cas des cellules monofaciales). Le courant électrique circule ensuite d'une cellule à l'autre de la chaîne par des interconnexions.

L'utilisation de matériau polymère ou composite en face avant, qui sont des matériaux considérés comme diélectriques (isolant), avec une forte résistivité de surface, peut mener à l'accumulation de charges électrostatiques à la surface, notamment lors de certaines opérations spécifique (chauffage sous vide entre deux nappes, frottement) ou après une durée de fonctionnement dans certains environnements (frottement de l'air notamment). Ce phénomène est encore plus important lorsque la taille du module augmente. Lorsque la concentration devient trop importante et que la tension associée est supérieure à la rigidité diélectrique du matériau, il peut se produire un arc électrique entre la cellule photovoltaïque et la surface extérieure.

Dans le meilleur des cas, ce claquage peut engendrer uniquement un micro trou dans la face avant du module, avec un impact sur la cellule sans dégradation des performances électriques du module. Dans le pire des cas, ce claquage peut conduire à un incendie du module, et donc potentiellement de l'objet sur lequel il est intégré.

L'accumulation de charges électrostatiques représente donc un danger pour le fonctionnement et l'intégrité du module photovoltaïque, ainsi que pour l'opérateur lors de certaines opérations de fabrication et/ou de maintenance.

Aussi, il existe un besoin pour fournir une architecture de module photovoltaïque permettant l'écoulement et l'évacuation de charges électrostatiques pouvant se former sur la surface du module, et qui pourraient être à l'origine de la formation d'arcs électriques pouvant engendrer la dégradation du module photovoltaïque, voire la destruction totale du dispositif intégrant le module, par exemple un engin en mouvement.

Les documents US5919316 A et US2003034062 A1 décrivent un module photovoltaïque comprenant des éléments conducteurs formant une protection électrostatique.

### EXPOSÉ DE L'INVENTION

L'invention a pour but de remédier au moins partiellement aux besoins mentionnés précédemment et aux inconvénients relatifs aux réalisations de l'art antérieur.

L'invention a ainsi pour objet, selon l'un de ses aspects, un module photovoltaïque comportant :
- une première couche transparente formant la face avant du module photovoltaïque, destinée à recevoir un flux lumineux,
- une pluralité de cellules photovoltaïques disposées côte à côte et reliées électriquement entre elles,
- un ensemble encapsulant la pluralité de cellules photovoltaïques,
- une deuxième couche formant la face arrière du module photovoltaïque, l'ensemble encapsulant et la pluralité de cellules photovoltaïques étant situés entre les première et deuxième couches,

caractérisé en ce que la deuxième couche comporte une couche conductrice électriquement pourvue d'un matériau conducteur électriquement, pour former une face arrière conductrice électriquement du module photovoltaïque, et isolée électriquement des cellules photovoltaïques,
et en ce qu'au moins un élément de liaison conducteur électriquement, notamment une pluralité d'éléments de liaison conducteurs électriquement, s'étend depuis la première couche vers la couche conductrice électriquement, dans l'épaisseur du module photovoltaïque comprise entre la première couche et la couche conductrice électriquement, pour permettre l'évacuation de charges électrostatiques accumulées au niveau de la première couche vers la couche conductrice, ledit au moins un élément de liaison conducteur étant disposé dans une zone dépourvue de connectique électrique reliant les cellules photovoltaïques entre elles.

Le terme « transparent » signifie que le matériau de la première couche formant la face avant du module photovoltaïque est au moins partiellement transparent à la lumière visible, laissant passer au moins environ 80 % de cette lumière.

En outre, par le terme « encapsulant », il faut comprendre que la pluralité de cellules photovoltaïques est disposée dans un volume, par exemple hermétiquement clos vis-à-vis des liquides, au moins en partie formé par au moins une couche composée d'un matériau polymère dit d'encapsulation. En général, on utilise au moins deux couches d'encapsulation disposées de part et d'autre des cellules photovoltaïques et réunies entre elles après assemblage, notamment par lamination, pour former l'ensemble encapsulant les cellules. Ainsi, initialement, c'est-à-dire avant toute opération d'assemblage, l'ensemble encapsulant peut être constitué par au moins deux couches de matériau d'encapsulation, dites couches de coeur, entre lesquelles la pluralité de cellules photovoltaïques est encapsulée. Toutefois, pendant l'opération d'assemblage, le ou les matériaux d'encapsulation fondent pour ne former, après l'opération d'assemblage, qu'une seule couche (ou ensemble) solidifiée dans laquelle sont noyées ou encapsulées les cellules photovoltaïques.

Grâce à l'invention, il peut être possible d'écouler les charges électrostatiques accumulées à la surface de la première couche vers une couche conductrice par le biais d'au moins un élément de liaison conducteur formant un « pont conducteur » au sein de l'architecture du module.

Le module photovoltaïque selon l'invention peut en outre comporter l'une ou plusieurs des caractéristiques suivantes prises isolément ou suivant toutes combinaisons techniques possibles.

Ledit au moins un élément de liaison conducteur peut préférentiellement s'étendre sensiblement perpendiculairement aux première et deuxième couches du module photovoltaïque et peut déboucher sur la surface extérieure de la première couche, notamment de manière à avoir une sensible continuité de surface extérieure entre la première couche et ledit au moins un élément de liaison conducteur.

La couche conductrice peut comporter au moins un matériau conducteur électriquement.

Elle peut notamment être constituée par un matériau conducteur électriquement, notamment une feuille métallique, par exemple en aluminium ou en cuivre. Elle peut aussi être constituée par une couche élastomère silicone chargée en particules conductrices, par exemple le cuivre ou l'argent.

En variante, elle peut comporter un matériau composite comprenant un élément de renfort conducteur électriquement, notamment en carbone. Il peut notamment s'agir de fibres de carbone pré imprégnées dans une résine, par exemple une résine époxy, polyester ou acrylique.

Par ailleurs, ledit au moins un élément de liaison conducteur peut être disposé dans une zone située entre les cellules photovoltaïques et/ou sur au moins un bord du module photovoltaïque.

Les cellules photovoltaïques peuvent être sensiblement de forme carrée et réparties en séries (ou chaînes) de cellules photovoltaïques interconnectées. Ledit au moins un élément de liaison conducteur peut être disposé dans une zone située entre les séries de cellules photovoltaïques et/ou située entre quatre sommets adjacents de quatre cellules photovoltaïques adjacentes respectives, cette zone étant couramment appelée « pseudo square ».

En outre, ledit au moins un élément de liaison conducteur peut présenter, en section transversale par rapport à l'épaisseur du module photovoltaïque, une forme sensiblement polygonale, par exemple rectangulaire ou carrée, et/ou une forme circulaire.

Ledit au moins un élément de liaison conducteur peut par exemple comporter un oeillet métallique perforé sur le module photovoltaïque.

Le module photovoltaïque peut comporter, dans un mode de réalisation spécifique, une pluralité d'éléments de liaison conducteurs en un nombre inférieur ou égal au nombre de cellules photovoltaïques.

Par ailleurs, la première couche peut comporter une ou plusieurs couches en matériau polymère, choisi notamment parmi le polyfluorure de vinylidène (PVDF), l'éthylène tétrafluoroéthylène (ETFE), l'éthylène chlorotrifluoroéthylène (ECTFE), l'éthylène propylène fluoré (FEP), le polyméthacrylate de méthyle (PMMA) et/ou le polycarbonate (PC), et/ou en matériau composite, notamment de type préimprégné avec renfort de type verre, entre autres.

De plus, la deuxième couche peut comporter uniquement la couche conductrice. En variante, la deuxième couche peut comporter, en plus de la couche conductrice, une ou plusieurs couches en matériau polymère, choisi notamment parmi le polyfluorure de vinylidène (PVDF), l'éthylène tétrafluoroéthylène (ETFE), l'éthylène chlorotrifluoroéthylène (ECTFE), l'éthylène propylène fluoré (FEP), le polyméthacrylate de méthyle (PMMA) et/ou le polycarbonate (PC), et/ou en matériau composite, notamment de type préimprégné avec renfort de type verre, entre autres.

Au moins un élément de liaison conducteur additionnel peut s'étendre depuis ladite une ou plusieurs couches en matériau polymère vers la couche conductrice pour permettre l'évacuation de charges électrostatiques accumulées au niveau de ladite une ou plusieurs couches en matériau polymère vers la couche conductrice.

En outre, l'ensemble encapsulant peut être réalisé à partir d'au moins un matériau polymère choisi parmi : les copolymères d'acides, les ionomères, le poly(éthylène-acétate de vinyle) (EVA), les acétals de vinyle , tels que les polyvinylbutyrals (PVB), les polyuréthanes, les chlorures de polyvinyle, les polyéthylènes, tels que les polyéthylènes linéaires basse densité, les polyoléfines élastomères de copolymères, les copolymères d'a-oléfines et des α-, β- esters d'acide carboxylique à éthylénique, tels que les copolymères éthylène-acrylate de méthyle et les copolymères éthylène-acrylate de butyle, les élastomères de silicone et/ou les résines époxy, entre autres.

L'ensemble encapsulant peut préférentiellement être réalisé à partir de deux couches de poly(éthylène-acétate de vinyle) (EVA) entre lesquelles sont disposées les cellules photovoltaïques.

Avantageusement, la première couche et la deuxième couche peuvent être dépourvues d'une couche en verre.

Le module photovoltaïque peut préférentiellement présenter une masse surfacique inférieure à 1 kg/m², et de préférence inférieure à 800 g/m².

De plus, le module photovoltaïque peut préférentiellement présenter une épaisseur inférieure à 2 mm.

Les cellules photovoltaïques peuvent être choisies parmi : des cellules photovoltaïques homojonction ou hétérojonction à base de silicium monocristallin (c-Si) et/ou multi-cristallin (mc-Si), et/ou des cellules photovoltaïques comprenant au moins un matériau parmi le silicium amorphe (a-Si), le silicium microcristallin (µC-Si), le tellurure de cadmium (CdTe), le cuivre-indium séléniure (CIS) et le cuivre-indium/gallium diséléniure (CIGS), entre autres. Par ailleurs, les cellules photovoltaïques peuvent présenter une épaisseur comprise entre 1 et 300 µm.

Par ailleurs, quand bien même la première couche formant la face avant du module photovoltaïque est transparente, la deuxième couche formant la face arrière du module photovoltaïque peut être ou non transparente, étant notamment opaque.

### BRÈVE DESCRIPTION DES DESSINS

L'invention pourra être mieux comprise à la lecture de la description détaillée qui va suivre, d'exemples de mise en oeuvre non limitatifs de celle-ci, ainsi qu'à l'examen des figures, schématiques et partielles, du dessin annexé, sur lequel :
Figure 1 représente, en coupe, un exemple classique de module photovoltaïque comportant des cellules photovoltaïques cristallines,
Figure 2 représente, en vue éclatée, le module photovoltaïque de la Figure 1,
Figure 3 représente, selon une vue en coupe partielle, un exemple de module photovoltaïque conforme à l'invention,
Figure 4 représente, selon une vue de dessus, le module photovoltaïque de la Figure 3, et
Figure 5 illustre schématiquement, selon une vue de dessus, un autre exemple de module photovoltaïque conforme à l'invention.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Les figures 1 et 2 ont déjà été décrites dans la partie relative à l'état de la technique antérieure et au contexte technique de l'invention.

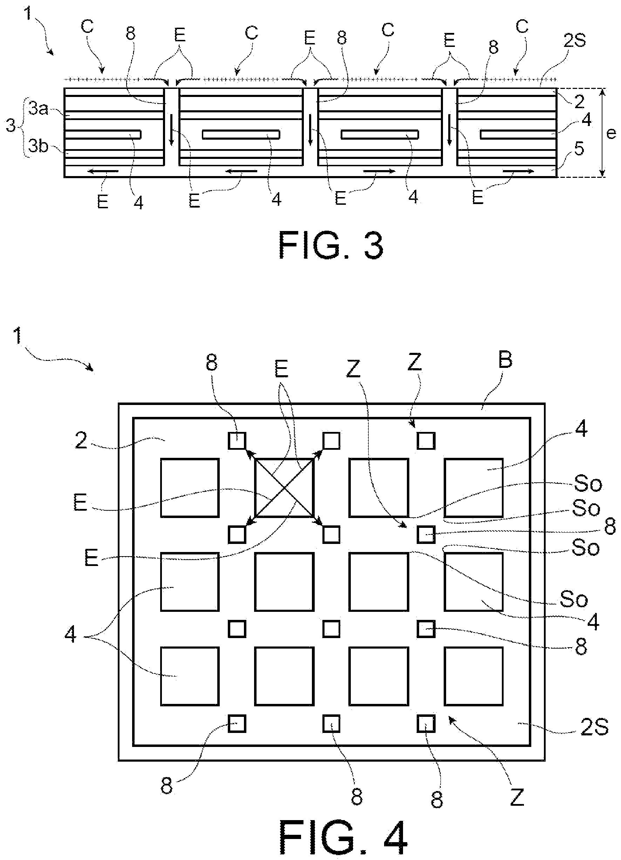

Les éléments communs aux figures 1 et 2 et aux figures 3 à 5 ne sont donc pas nécessairement décrits de nouveau.

En référence aux figures 3 et 4, on a représenté, respectivement selon une vue en coupe partielle et selon une vue de dessus partielle, un exemple de module photovoltaïque 1 conforme à l'invention.

De façon préférentielle, ce module photovoltaïque 1 est dépourvu de verre. De plus, c'est un module ultra-léger avec une masse surfacique inférieure à 1 kg/m², et de préférence inférieure à 800 g/m², et une épaisseur inférieure à 2 mm.

Le module photovoltaïque 1 comporte ainsi une première couche 2 transparente formant la face avant et destinée à recevoir un flux lumineux, des cellules photovoltaïques 4, ici au nombre de douze, disposées côte à côte et reliées électriquement entre elles, un ensemble encapsulant 3 les cellules photovoltaïques 4 formé par la réunion d'une première couche 3a et d'une deuxième couche 3b, et une deuxième couche 5 formant la face arrière du module photovoltaïque 1.

Conformément à l'invention, la deuxième couche 5 comporte une couche conductrice électriquement. Dans cet exemple, et bien que cela ne soit pas limitatif, la deuxième couche 5 est uniquement constituée par la couche conductrice 5.

Cette couche conductrice 5 est pourvue d'un matériau conducteur électriquement, pour former une face arrière conductrice électriquement du module photovoltaïque 1. Par exemple, la couche conductrice 5 peut être une feuille métallique, par exemple le cuivre ou l'aluminium, ou comporter un préimprégné avec un renfort carbone. De plus, elle est isolée électriquement des cellules photovoltaïques 4 par l'ensemble encapsulant 3 afin de ne pas créer de court-circuit.

Par ailleurs, des éléments de liaison conducteurs électriquement 8, ici au nombre de douze identique au nombre de cellules photovoltaïques 4, s'étendent depuis la première couche 2 vers la couche conductrice électriquement 5, dans l'épaisseur e du module photovoltaïque 1 comprise entre la première couche 2 et la couche conductrice électriquement 5, pour permettre l'évacuation, symbolisée par les flèches E sur les figures 3 et 4, de charges électrostatiques C, représentées par des « + » sur la figure 3, accumulées au niveau de la première couche 2 vers la couche conductrice 5.

Ainsi, il est possible de créer des « ponts conducteurs » par le biais des éléments de liaison conducteurs 8 entre la face avant et la face arrière du module photovoltaïque 1 de manière à obtenir des chemins d'écoulement des charges électrostatiques C.

Les éléments de liaison conducteurs 8 s'étendent perpendiculairement aux première 2 et deuxième 5 couches du module photovoltaïque 1 et débouchent sur la surface extérieure 2S de la première couche 2 de manière à avoir une sensible continuité de surface extérieure entre la première couche 2 et les éléments de liaison conducteurs 8.

De plus, ces éléments de liaison conducteurs 8 sont avantageusement disposés dans des zones Z dépourvues de connectique électrique reliant les cellules photovoltaïques 4 entre elles. Par exemple, ils peuvent être situés dans des zones Z situées entre les cellules photovoltaïques 4 et/ou sur au moins un bord B du module photovoltaïque 1.

De préférence, comme selon l'exemple des figures 3 et 4, les cellules photovoltaïques 4 sont de forme carrée et réparties en séries S de cellules photovoltaïques 4 interconnectées, comme décrit précédemment en référence à la figure 2. Alors, les éléments de liaison conducteurs 8 sont avantageusement disposés dans une zone Z située entre les séries S de cellules photovoltaïques 4 ou bien encore, comme c'est le cas ici pour les figures 3 et 4, ils sont situés entre quatre sommets So adjacents de quatre cellules photovoltaïques 4 adjacentes respectives, c'est-à-dire au niveau des angles, comme visible sur la figure 4, cette zone étant couramment appelée « pseudo square ». Cette zone est avantageuse dans la mesure où elle est dépourvue de connectique électrique et car il s'agit également d'une surface perdue pour la production électrique. L'ajout des éléments de liaison conducteurs 8 dans cette zone permet de conserver un taux classique de remplissage de cellules 4 dans le module 1, et n'engendre donc pas de perte de surface active du module photovoltaïque 1.

Ainsi, l'accumulation de charges électrostatiques C à la surface 2S de la première couche 2 est évacuée au niveau des points de conduction formés les éléments de liaison conducteurs aux intersections des cellules 4. Le chemin à parcourir pour les charges électrostatiques C est donc considérablement réduit grâce à ces ponts conducteurs. La face arrière conductrice permet ensuite d'évacuer les charges électrostatiques C à l'extérieur du module photovoltaïque 1 ou à un réseau de masse.

De cette façon, l'invention permet de conserver les avantages d'un module classique, notamment un module ultra-léger et/ou avec une face avant polymère présentant une résistivité de surface importante, en particulier en termes de masse surfacique ou de performances, et peut être appliquée à tout type de module photovoltaïque dont la face avant est sensible au chargement électrostatique.

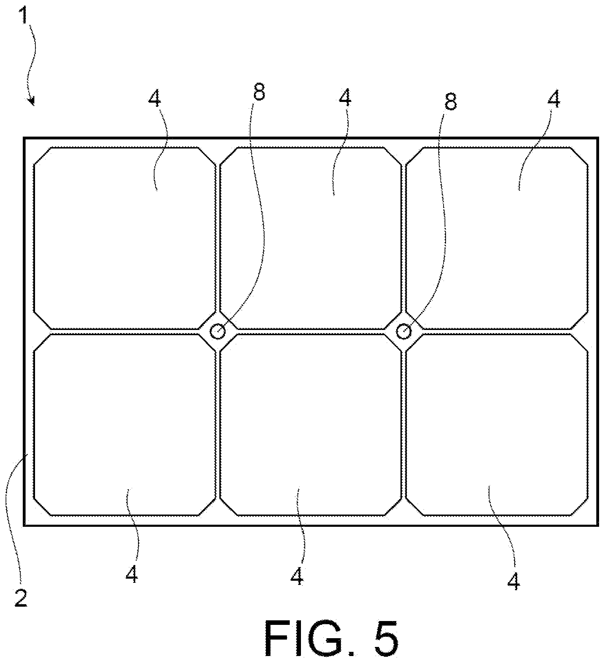

Par ailleurs, la figure 5 représente, selon une vue de dessus partielle, un autre exemple de module photovoltaïque 1 conforme à l'invention.

De manière non limitative, ce module 1 est un module ultra-léger avec des matériaux minces en face avant, par exemple un film polymère fluoré, et en face arrière, par exemple un préimprégné avec renfort carbone et résine époxy.

Également de manière nullement limitative, deux éléments de liaison conducteurs 8 sont utilisés aux intersections de six cellules photovoltaïques 4.

Ces éléments de liaison conducteurs 8 sont par exemple sous la forme d'oeillets métalliques perforés sur le module photovoltaïque 1, et reliant électriquement la face avant à la face arrière conductrice.

L'ajout de tels oeillets métalliques est réalisé dans les zones Z dites « pseudo square » comme précédemment décrit. Cela pourrait également se faire au niveau d'un ou plusieurs bords B du module ou entre les séries S de cellules 4.

La densité des points de conduction formés par les éléments de liaison conducteurs 8 peut être différente en fonction de la résistivité surfacique du matériau utilisé en face avant du module photovoltaïque 1 et de l'application finale (dynamique de chargement électrostatique).

Par ailleurs, l'utilisation d'oeillets métalliques pour former les éléments de liaison conducteurs 8 offre une bonne résistance au vent. Les trous formés par les oeillets permettent de diminuer la prise au vent du module photovoltaïque 1 et ainsi de diminuer les contraintes mécaniques sur le module et sur les fixations en cours d'utilisation.

Bien entendu, l'invention n'est pas limitée aux exemples de réalisation qui viennent d'être décrits. Diverses modifications peuvent y être apportées par l'homme du métier, tant qu'elles restent couvertes par l'objet des revendications.

## Revendications

1. Module photovoltaïque (1) comportant :
- une première couche (2) transparente formant la face avant du module photovoltaïque (1), destinée à recevoir un flux lumineux,
- une pluralité de cellules photovoltaïques (4) disposées côte à côte et reliées électriquement entre elles,
- un ensemble encapsulant (3) la pluralité de cellules photovoltaïques (4),
- une deuxième couche (5) formant la face arrière du module photovoltaïque (1), l'ensemble encapsulant (3) et la pluralité de cellules photovoltaïques (4) étant situés entre les première (2) et deuxième (5) couches,
dans lequel la deuxième couche (5) comporte une couche conductrice électriquement (5) pourvue d'un matériau conducteur électriquement, pour former une face arrière conductrice électriquement du module photovoltaïque (1), et isolée électriquement des cellules photovoltaïques (4),
et dans lequel au moins un élément de liaison conducteur électriquement (8) s'étend depuis la première couche (2) vers la couche conductrice électriquement (5), dans l'épaisseur (e) du module photovoltaïque (1) comprise entre la première couche (2) et la couche conductrice électriquement (5), pour permettre l'évacuation de charges électrostatiques accumulées au niveau de la première couche (2) vers la couche conductrice (5), ledit au moins un élément de liaison conducteur (8) étant disposé dans une zone (Z) dépourvue de connectique électrique reliant les cellules photovoltaïques (4) entre elles.

2. Module selon la revendication 1, **caractérisé en ce que** ledit au moins un élément de liaison conducteur (8) s'étend sensiblement perpendiculairement aux première (2) et deuxième (5) couches du module photovoltaïque (1) et débouche sur la surface extérieure (2S) de la première couche (2), notamment de manière à avoir une sensible continuité de surface extérieure entre la première couche (2) et ledit au moins un élément de liaison conducteur (8).

3. Module selon la revendication 1 ou 2, **caractérisé en ce que** la couche conductrice (5) comporte au moins un matériau conducteur électriquement.

4. Module selon la revendication 3, **caractérisé en ce que** la couche conductrice (5) est constituée par un matériau conducteur électriquement, notamment une feuille métallique, par exemple en aluminium ou en cuivre.

5. Module selon la revendication 3, **caractérisé en ce que** la couche conductrice (5) comporte un matériau composite comprenant un élément de renfort conducteur électriquement, notamment en carbone.

6. Module selon l'une quelconque des revendications précédentes, **caractérisé en ce que** ledit au moins un élément de liaison conducteur (8) est disposé dans une zone (Z) située entre les cellules photovoltaïques (4) et/ou sur au moins un bord (B) du module photovoltaïque (1).

7. Module selon l'une quelconque des revendications précédentes, **caractérisé en ce que** les cellules photovoltaïques (4) sont sensiblement de forme carrée et réparties en séries (S) de cellules photovoltaïques (4) interconnectées, et **en ce que** ledit au moins un élément de liaison conducteur (8) est disposé dans une zone (Z) située entre les séries (S) de cellules photovoltaïques (4) et/ou située entre quatre sommets (So) adjacents de quatre cellules photovoltaïques (4) adjacentes respectives.

8. Module selon l'une quelconque des revendications précédentes, **caractérisé en ce que** ledit au moins un élément de liaison conducteur (8) présente, en section transversale par rapport à l'épaisseur (e) du module photovoltaïque (1), une forme sensiblement polygonale, par exemple rectangulaire ou carrée, et/ou une forme circulaire.

9. Module selon l'une quelconque des revendications précédentes, **caractérisé en ce que** ledit au moins un élément de liaison conducteur (8) comporte un oeillet métallique perforé sur le module photovoltaïque (1).

10. Module selon l'une quelconque des revendications précédentes, **caractérisé en ce qu'**il comporte une pluralité d'éléments de liaison conducteurs (8) en un nombre inférieur ou égal au nombre de cellules photovoltaïques (4).

11. Module selon l'une quelconque des revendications précédentes, **caractérisé en ce que** la première couche (2) comporte une ou plusieurs couches en matériau polymère, choisi notamment parmi le polyfluorure de vinylidène (PVDF), l'éthylène tétrafluoroéthylène (ETFE), l'éthylène chlorotrifluoroéthylène (ECTFE), l'éthylène propylène fluoré (FEP), le polyméthacrylate de méthyle (PMMA) et/ou le polycarbonate (PC), et/ou en matériau composite, notamment de type préimprégné avec renfort de type verre.

12. Module selon l'une quelconque des revendications précédentes, **caractérisé en ce que** la deuxième couche (5) comporte uniquement la couche conductrice (5).

13. Module selon l'une quelconque des revendications 1 à 11, **caractérisé en ce que** la deuxième couche (5) comporte, en plus de la couche conductrice, une ou plusieurs couches en matériau polymère, choisi notamment parmi le polyfluorure de vinylidène (PVDF), l'éthylène tétrafluoroéthylène (ETFE), l'éthylène chlorotrifluoroéthylène (ECTFE), l'éthylène propylène fluoré (FEP), le polyméthacrylate de méthyle (PMMA) et/ou le polycarbonate (PC), et/ou en matériau composite, notamment de type préimprégné avec renfort de type verre,
et **en ce qu'**au moins un élément de liaison conducteur (8) additionnel s'étend depuis ladite une ou plusieurs couches en matériau polymère vers la couche conductrice pour permettre l'évacuation de charges électrostatiques accumulées au niveau de ladite une ou plusieurs couches en matériau polymère vers la couche conductrice.

14. Module selon l'une quelconque des revendications précédentes, **caractérisé en ce que** l'ensemble encapsulant (3) est réalisé à partir d'au moins un matériau polymère choisi parmi : les copolymères d'acides, les ionomères, le poly(éthylène-acétate de vinyle) (EVA), les acétals de vinyle , tels que les polyvinylbutyrals (PVB), les polyuréthanes, les chlorures de polyvinyle, les polyéthylènes, tels que les polyéthylènes linéaires basse densité, les polyoléfines élastomères de copolymères, les copolymères d'a-oléfines et des α-, β- esters d'acide carboxylique à éthylénique, tels que les copolymères éthylène-acrylate de méthyle et les copolymères éthylène-acrylate de butyle, les élastomères de silicone et/ou les résines époxy.

15. Module selon l'une quelconque des revendications précédentes, **caractérisé en ce que** la première couche (2) et la deuxième couche (5) sont dépourvues d'une couche en verre.

16. Module selon l'une quelconque des revendications précédentes, **caractérisé en ce qu'**il présente une masse surfacique inférieure à 1 kg/m², notamment inférieure à 800 g/m².

17. Module selon l'une quelconque des revendications précédentes, **caractérisé en ce qu'**il présente une épaisseur (e) inférieure à 2 mm.

## Patentansprüche

1. Photovoltaikmodul (1), beinhaltend:
- eine erste transparente Schicht (2), die die Vorderseite des Photovoltaikmoduls (1) bildet, die bestimmt ist, um einen Lichtstrom zu empfangen,
- eine Vielzahl von Photovoltaikzellen (4), die nebeneinander positioniert und elektrisch miteinander verbunden sind,
- eine Einheit (3), die die Vielzahl von Photovoltaikzellen (4) verkapselt,
- eine zweite Schicht (5), die die Rückseite des Photovoltaikmoduls (1) bildet, wobei die Verkapselungseinheit (3) und die Vielzahl von Photovoltaikzellen (4) zwischen der ersten (2) und der zweiten (5) Schicht angeordnet sind,
wobei die zweite Schicht (5) eine elektrisch leitfähige Schicht (5) beinhaltet, die mit einem elektrisch leitfähigen Material versehen ist, um eine Rückseite des Photovoltaikmoduls (1) zu bilden, die elektrisch leitfähig ist, und der Photovoltaikzellen (4), die elektrisch isoliert ist, und
wobei sich mindestens ein elektrisch leitfähiges Verbindungselement (8) von der ersten Schicht (2) zur elektrisch leitfähigen Schicht (5) erstreckt, in der Dicke (e) des Photovoltaikmoduls (1) zwischen der ersten Schicht (2) und der elektrisch leitfähigen Schicht (5), um die Ableitung der elektrostatischen Ladungen zu ermöglichen, die sich im Bereich der ersten Schicht (2) angesammelt haben, zur leitfähigen Schicht (5), wobei das mindestens eine leitfähige Verbindungselement (8) in einer Zone (Z) positioniert ist, die über keine elektrische Verbindung verfügt, die die Photovoltaikzellen (4) miteinander verbindet.

2. Modul nach Anspruch 1, **dadurch gekennzeichnet, dass** sich das mindestens eine leitfähige Verbindungselement (8) im Wesentlichen perpendikular zur ersten (2) und zweiten (5) Schicht des Photovoltaikmoduls (1) erstreckt und in der äußeren Oberfläche (2S) der ersten Schicht (2) ausmündet, insbesondere um eine empfindliche Kontinuität der äußeren Oberfläche zwischen der ersten Schicht (2) und dem mindestens einen leitfähigen Verbindungselement (8) zu gewährleisten.

3. Modul nach Anspruch 1 oder 2, **dadurch gekennzeichnet, dass** die leitfähige Schicht (5) mindestens ein elektrisch leitfähiges Material beinhaltet.

4. Modul nach Anspruch 3, **dadurch gekennzeichnet, dass** die leitfähige Schicht (5) aus einem elektrisch leitfähigen Material besteht, insbesondere einer Metallfolie, beispielsweise aus Aluminium oder Kupfer.

5. Modul nach Anspruch 3, **dadurch gekennzeichnet, dass** die leitfähige Schicht (5) einen Verbundwerkstoff beinhaltet, der ein Element der elektrischen Leitfähigkeitsverstärkung umfasst, insbesondere Kohlenstoff.

6. Modul nach einem der vorhergehenden Ansprüche, **dadurch gekennzeichnet, dass** das mindestens eine leitfähige Verbindungselement (8) in einer Zone (Z) positioniert ist, die zwischen den Photovoltaikzellen (4) angeordnet ist, und/oder an mindestens einer Kante (B) des Photovoltaikmoduls (1).

7. Modul nach einem der vorhergehenden Ansprüche, **dadurch gekennzeichnet, dass** die Photovoltaikzellen (4) im Wesentlichen von quadratischer Form sind und in Reihen (S) miteinander verbundener Photovoltaikzellen (4) verteilt sind, und dass das mindestens eine leitfähige Verbindungselement (8) in einer Zone (Z) positioniert ist, die zwischen den Reihen (S) von Photovoltaikzellen (4) angeordnet ist, und/oder zwischen vier benachbarten Scheitelpunkten (So) von vier jeweiligen benachbarten Photovoltaikzellen (4) angeordnet ist.

8. Modul nach einem der vorhergehenden Ansprüche, **dadurch gekennzeichnet, dass** das mindestens eine leitfähige Verbindungselement (8) im Querschnitt relativ zur Dicke (e) des Photovoltaikmoduls (1) eine im Wesentlichen polygonale Form aufweist, beispielsweise rechteckig oder quadratisch, und/oder eine kreisförmige Form.

9. Modul nach einem der vorhergehenden Ansprüche, **dadurch gekennzeichnet, dass** das mindestens eine leitfähige Verbindungselement (8) eine Metallöse beinhaltet, die am Photovoltaikmodul (1) perforiert ist.

10. Modul nach einem der vorhergehenden Ansprüche, **dadurch gekennzeichnet, dass** es eine Vielzahl leitfähiger Verbindungselemente (8) in einer Anzahl beinhaltet, die kleiner oder gleich der Anzahl der Photovoltaikzellen (4) ist.

11. Modul nach einem der vorhergehenden Ansprüche, **dadurch gekennzeichnet, dass** die erste Schicht (2) eine oder mehrere Polymermaterialschichten beinhaltet, insbesondere ausgewählt aus Polyvinylidenfluorid (PVDF), Ethylen-Tetrafluorethylen-Copolymer (ETFE), Ethylen-Chlortrifluorethylen (ECTFE), fluoriertem Ethylenpropylen (FEP), Polymethylmethacrylat (PMMA) und/oder Polycarbonat (PC) und/oder Verbundwerkstoff, insbesondere vom Typ Prepreg mit einer Verstärkung vom Typ Glas.

12. Modul nach einem der vorhergehenden Ansprüche, **dadurch gekennzeichnet, dass** die zweite Schicht (5) nur die leitfähige Schicht (5) beinhaltet.

13. Modul nach einem der Ansprüche 1 bis 11, **dadurch gekennzeichnet, dass** die zweite Schicht (5) zusätzlich zur leitfähigen Schicht eine oder mehrere Polymermaterialschichten beinhaltet, insbesondere ausgewählt aus Polyvinylidenfluorid (PVDF), Ethylen-Tetrafluorethylen-Copolymer (ETFE), Ethylen-Chlortrifluorethylen (ECTFE), fluoriertem Ethylenpropylen (FEP), Polymethylmethacrylat (PMMA) und/oder Polycarbonat (PC) und/oder Verbundwerkstoff, insbesondere vom Typ Prepreg mit einer Verstärkung vom Typ Glas,
und dass sich mindestens ein zusätzliches leitfähiges Verbindungselement (8) von der einen oder den mehreren Polymermaterialschichten in Richtung der leitfähigen Schicht erstreckt, um die Ableitung der elektrostatischen Ladungen zu ermöglichen, die sich im Bereich der einen oder der mehreren Polymermaterialschichten angesammelten haben, zur leitfähigen Schicht.

14. Modul nach einem der vorhergehenden Ansprüche, **dadurch gekennzeichnet, dass** die Verkapselungseinheit (3) aus mindestens einem Polymermaterial hergestellt ist, das ausgewählt ist aus: Säurecopolymeren, lonomeren, Poly(ethylen-co-vinylacetaten) (EVA), Vinylacetaten, wie Polyvinylbutyralen (PVB), Polyurethanen, Polyvinylchloriden, Polyethylenen, wie linearen Polyethylenen niedriger Dichte, elastomeren Polyolefinen von Copolymeren, Copolymere von α-Olefinen, und α-, β-Estern von Ethylen-Carbonsäure, wie Ethylen-Methylacrylat-Copolymere, und Ethylen-Butylacrylat-Copolymere, Silikonelastomere und/oder Epoxidharze.

15. Modul nach einem der vorhergehenden Ansprüche, **dadurch gekennzeichnet, dass** die erste Schicht (2) und die zweite Schicht (5) über keine Glasschicht verfügen.

16. Modul nach einem der vorhergehenden Ansprüche, **dadurch gekennzeichnet, dass** es eine Flächenmasse von weniger als 1 kg/m² aufweist, insbesondere weniger als 800 g/m².

17. Modul nach einem der vorhergehenden Ansprüche, **dadurch gekennzeichnet, dass** es eine Dicke (e) von weniger als 2 mm aufweist.

## Claims

1. A photovoltaic module (1) including:
- a transparent first layer (2) forming the front face of the photovoltaic module (1), for receiving a luminous flux,
- a plurality of photovoltaic cells (4) disposed side by side and electrically connected to each other,
- an assembly (3) encapsulating the plurality of photovoltaic cells (4),
- a second layer (5) forming the rear face of the photovoltaic module (1), the encapsulating assembly (3) and the plurality of photovoltaic cells (4) being located between the first (2) and second (5) layers,
wherein the second layer (5) includes an electrically conductive layer (5) provided with an electrically conductive material, to form an electrically conductive rear face of the photovoltaic module (1), and electrically insulated from the photovoltaic cells (4),
and wherein at least one electrically conductive connection element (8) extends from the first layer (2) to the electrically conductive layer (5), in the thickness (e) of the photovoltaic module (1) included between the first layer (2) and the electrically conductive layer (5), to allow evacuation of electrostatic charges built up at the first layer (2) towards the conductive layer (5), said at least one conductive connection element (8) being disposed in a zone (Z) devoid of electric connectivity connecting the photovoltaic cells (4) to each other.

2. The module according to claim 1, **characterised in that** said at least one conductive connection element (8) extends substantially perpendicular to the first (2) and second (5) layers of the photovoltaic module (1) and opens onto the external surface (2S) of the first layer (2), especially so as to have a substantial external surface continuity between the first layer (2) and said at least one conductive connection element (8).

3. The module according to claim 1 or 2, **characterised in that** the conductive layer (5) includes at least one electrically conductive material.

4. The module according to claim 3, **characterised in that** the conductive layer (5) consists of an electrically conductive material, especially a metal sheet, for example of aluminium or copper.

5. The module according to claim 3, **characterised in that** the conductive layer (5) includes a composite material comprising an electrically conductive reinforcement element, especially of carbon.

6. The module according to any of the preceding claims, **characterised in that** said at least one conductive connection element (8) is disposed in a zone (Z) located between the photovoltaic cells (4) and/or on at least one edge (B) of the photovoltaic module (1).

7. The module according to any of the preceding claims, **characterised in that** the photovoltaic cells (4) are substantially of a square shape and distributed in series (S) of interconnected photovoltaic cells (4), and **in that** said at least one conductive connection element (8) is disposed in a zone (Z) located between the series (S) of photovoltaic cells (4) and/or located between four adjacent apexes (So) of four respective adjacent photovoltaic cells (4).

8. The module according to any of the preceding claims, **characterised in that** said at least one conductive connection element (8) has, in a transverse cross-section relative to the thickness (e) of the photovoltaic module (1), a substantially polygonal, for example rectangular or square, shape and/or a circular shape.

9. The module according to any of the preceding claims, **characterised in that** said at least one conductive connection element (8) includes a perforated metal eyelet on the photovoltaic module (1).

10. The module according to any of the preceding claims, **characterised in that** it includes a plurality of conductive connection elements (8) in a number less than or equal to the number of photovoltaic cells (4).

11. The module according to any of the preceding claims, **characterised in that** the first layer (2) includes one or more layers of polymeric material, especially selected from polyvinylidene fluoride (PVDF), ethylene tetrafluoroethylene (ETFE), ethylene chlorotrifluoroethylene (ECTFE), fluorinated ethylene propylene (FEP), polymethyl methacrylate (PMMA) and/or polycarbonate (PC), and/or of composite material, especially of the pre-impregnated type with a glass type reinforcement.

12. The module according to any of the preceding claims, **characterised in that** the second layer (5) only includes the conductive layer (5).

13. The module according to any of claims 1 to 11, **characterised in that** the second layer (5) includes, in addition to the conductive layer, one or more layers of polymeric material, especially selected from polyvinylidene fluoride (PVDF), ethylene tetrafluoroethylene (ETFE), ethylene chlorotrifluoroethylene (ECTFE), fluorinated ethylene propylene (FEP), polymethyl methacrylate (PMMA) and/or polycarbonate (PC), and/or of composite material, especially of the pre-impregnated type with a glass type reinforcement,
and **in that** at least one additional conductive connection element (8) extends from said one or more layers of polymeric material towards the conductive layer to allow evacuation of electrostatic charges built up at said one or more layers of polymeric material towards the conductive layer.

14. The module according to any of the preceding claims, **characterised in that** the encapsulating assembly (3) is made from at least one polymeric material selected from: acid copolymers, ionomers, poly(ethylene-vinyl acetate) (EVA), vinyl acetals, polyvinyl butyrals (PVB), polyurethanes, polyvinyl chlorides, polyethylenes, such as low density linear polyethylenes, elastomeric polyolefins of copolymers, copolymers of α-olefins and α-, β-esters of carboxylic to ethylenic acids, such as ethylene-methyl acrylate copolymers and ethylene-butyl acrylate copolymers, silicone elastomers and/or epoxy resins.

15. The module according to any of the preceding claims, **characterised in that** the first layer (2) and the second layer (5) are devoid of a glass layer.

16. The module according to any of the preceding claims, **characterised in that** it has a mass per unit area less than 1 kg/m², especially less than 800 g/m².

17. The module according to any of the preceding claims, **characterised in that** it has a thickness (e) less than 2 mm.
